Europäisches Patentamt

(19) European Patent Office

Office européen des brevets

(11) Numéro de publication: **0 033 678**
**B1**

(12) **FASCICULE DE BREVET EUROPEEN**

(45) Date de publication du fascicule du brevet: **17.04.85**

(51) Int. Cl.⁴: **H 03 K 4/62**, H 04 N 3/18

(21) Numéro de dépôt: **81400068.3**

(22) Date de dépôt: **20.01.81**

(54) Procédé d'entretien pour un circuit électrique oscillant et dispositif de déviation horizontale pour tube cathodique mettant en oeuvre ce procédé.

(30) Priorité: **31.01.80 FR 8002055**
**05.11.80 FR 8023586**

(43) Date de publication de la demande:
**12.08.81 Bulletin 81/32**

(45) Mention de la délivrance du brevet:
**17.04.85 Bulletin 85/16**

(84) Etats contractants désignés:
**AT CH DE GB LI NL**

(56) Documents cités:
**EP-A-0 005 391**
**FR-A-2 118 894**
**GB-A-1 502 074**
**GB-A-2 002 984**
**GB-A-2 045 564**

**SIEMENS BAUTEILE REPORT, vol. 12, no. 3, juin 1974, MUNICH (DE), G. PERUTH et al.: "Pumpschaltung- ein fortschrittliches Transistorkonzept für Fernsehempfänger", pages 61-64**

(73) Titulaire: **VIDEOCOLOR**
**7, boulevard Romain-Rolland**
**F-92128 Montrouge (FR)**

(72) Inventeur: **Lamoureux, André**
**14, avenue Galliéni**
**F-91800 Brunoy (FR)**

(74) Mandataire: **Boireau, Jacques**
**Thomson-CSF SCPI 173, boulevard Haussmann**
**F-75379 Paris Cedex 08 (FR)**

(56) Documents cités:
**IEEE TRANSACTIONS ON CONSUMER ELECTRONICS, vol. CE-22, no. 4, novembre 1976, NEW YORK (US), W.F. DIETZ et al.: "Comparison of transistor and SCR deflection circuits for color television", pages 357-364**

Courier Press, Leamington Spa, England.

**Description**

L'invention concerne un procédé d'entretien d'un circuit électrique oscillant, pour le balayage ligne d'un tube cathodique ainsi qu'un dispositif de déviation horizontale pour un tel tube cathodique, mettant en oeuvre ce procédé. L'invention a plus particulièrement pour objet d'utiliser un unique transformateur, dit transformateur de ligne, non seulement pour entretenir le circuit oscillant comprenant le déviateur ligne du tube cathodique mais encore pour obtenir à partir de ce même transformateur, au moyen d'enroulements supplémentaires, un certain nombre de tension d'alimentation, stabilisées ou non, nécessaires au fonctionnement de l'appareil utilisant ledit tube cathodique, notamment un récepteur de télévision.

Sur les téléviseurs modernes, et notamment les récepteurs de télévision en couleurs, on prévoit souvent des organes périphériques de télécommande branchés sur le téléviseur. Ceci oblige à isoler soigneusement le secteur du châssis de l'appareil pour qu'aucun organe périphérique ne soit porté au potentiel du secteur, ce qui pourrait être dangereux pour l'utilisateur.

Par ailleurs, on a déjà cherché à combiner les circuits d'alimentation du téléviseur au circuit de déviation horizontale engendrant le balayage ligne sur le tube cathodique. Dans ce cas, le circuit de déviation et notamment le transformateur ligne est pourvu d'enroulements supplémentaires fournissant les différentes sources de puissance nécessaires au fonctionnement du téléviseur; le transformateur d'alimentation proprement dit étant supprimé. Ce système présente cependant un inconvénient provenant principalement du fait qu'un interrupteur commandé et interconnecté avec le circuit oscillant comprenant le déviateur ligne (ce circuit oscillant est composé dudit déviateur constitué par une bobine d'inductance et de deux condensateurs) pour court-circuiter l'un des composants de ce circuit oscillant pendant une période aller du balayage où le circuit oscillant fonctionne à une fréquence d'oscillation faible par rapport à une autre fréquence d'oscillation qui s'établit pendant le retour ligne. En effet, cet interrupteur commandé a également pour effet de court-circuiter un enroulement d'entretien du transformateur ligne, ce qui pose des problèms si un autre enroulement de ce même transformateur est simultanément connecté à une source d'alimentation provenant du secteur. On pourrait imaginer de résoudre ce problème en établissant un couplage relativement lâche entre les deux enroulements précités du transformateur ligne mais une telle solution semble peu satisfaisante en raison d'un rendement faible et surtout d'un niveau de rayonnement parasite important autour du transformateur ligne, susceptible de perturber les circuits électroniques voisins et surtout le tube cathodique lui-même.

Un article IEEE "Transactions on Consumer Electronics" Vol. CE—22 No. 4 novembre 1976 décrit à sa figure 12 un circuit de commande de balayage à thyristors utilisant un transformateur avec une grande inductance de fuite entre primaire et secondaire. Le Brevet Européen 0 005 391 décrit un système de balayage utilisant un composant magnétique supplémentaire en série avec l'enroulement primaire. Enfin, le Brevet britannique 2 002 984 décrit un système de balayage réalisant l'intégration de la fonction alimentation au niveau du transformateur ligne. Mais ce transformateur est bobiné avec un couplage lâche entre primaire et secondaire.

L'invention offre une solution satisfaisante à la fois au problème d'isolement galvanique entre le secteur et les différents constituants du téléviseur et le problème de l'intégration de la fonction alimentation au niveau des moyens de déviation horizontal de ce téléviseur.

Dans cet esprit, l'invention concerne principalement un procédé d'entretien d'un circuit électrique oscillant à deux fréquences d'oscillation commutables séquentiellement pour le balayage ligne d'un tube cathodique, du type consistant à induire de l'énergie d'entretien dans un premier enroulement inductif connecté audit circuit électrique oscillant au point commun de deux condensateurs de celui-ci et à court-circuiter périodiquement l'un desdits condensateurs, la fréquence d'oscillation la plus faible s'établissant pendant une période aller dudit balayage lorsque ce condensateur est court-circuité et la fréquence d'oscillation la plus élevée s'établissant pendant une période retour dudit balayage lorsque ce condensateur n'est pas court-circuité, caractérisé en ce qu'il consiste, au moyen d'un second enroulement inductif susceptible d'être branché à une source de tension continue et couplé audit premier enroulement avec un facteur de couplage électromagnétique élevé, au moyen d'un circuit magnétique:

— à interconnecter ledit second enroulement aux bornes de ladite source de tension continue au cours de chaque période aller précitée jusqu'à établir un niveau d'énergie prédéterminé dans ledit circuit magnétique, en maintenant ledit premier enroulement déconnecté dudit circuit électrique oscillant,
— à déconnecter ledit second enroulement de ladite source de tension lorsque ledit niveau d'énergie est atteint en connectant simultanément ledit premier enroulement aux bornes dudit condensateur court-circuité jusqu'à la fin de ladite période aller si ledit niveau d'énergie est atteint avant celle-ci,
— à ouvrir le court-circuit aux bornes dudit condensateur pendant toute la période retour en maintenant ledit premier enroulement connecté audit circuit électrique oscillant pendant au moins une partie de ladite période retour, et
— à déconnecter au début de la période aller du balayage ledit premier enroulement dudit circuit électrique oscillant et à connecter simultanément ledit second enroulement aux bornes de ladite source de tension continue, les étapes se répétant dans le temps sans que le premier enroulement puisse être court-circuité quand le second enroulement est connecté à la source de tension.

Bien entendu, ladite source de tension continue est simplement constituée par un pont redresseur, par exemple un pont à diodes, connecté au secteur, relié audit second enroulement par l'intermédiaire de moyens de filtrage appropriés. Pour répondre à l'un des objectifs de l'invention, cette source de tension continue peut être galvaniquement isolée du reste du châssis du téléviseur.

L'invention concerne également un dispositif de déviation horizontale d'un tube cathodique et d'alimentation, du type comportant:

— un circuit oscillant relié à un premier enroulement inductif et comprenant le déviateur dudit tube cathodique ainsi que deux condensateurs, l'un desdits condensateurs étant connecté entre un point de connexion dudit premier enroulement audit circuit oscillant et un point à un potentiel de référence,

— un premier interrupteur commandé connecté aux bornes de ce condensateur pour le court-circuiter pendant chaque période aller de balayage et le mettre en service dans ledit circuit oscillant pendant chaque période retour dudit balayage, et

— un second enroulement inductif couplé audit premier enroulement par un circuit magnétique et connecté à une source de tension continue par l'intermédiaire d'un second interrupteur commandé; le premier enroulement ne pouvant jamais être court-circuité quand le second enroulement est connecté à la source de tension, les interrupteurs commandés étant du type actif à commutation forcée dans un premier sens de conduction et à commutation naturelle dans le sens opposé;

— ledit dispositif étant caractérisé en ce que le couplage magnétique entre le premier et le second enroulement est élevé et en ce qu'il comporte en outre un troisième interrupteur inséré en série avec ledit premier enroulement entre ledit point à un potentiel de référence et ledit point de connexion. Il est en outre caractérisé en ce que selon un premier mode de réalisation le troisième interrupteur est un interrupteur commandé du type précité, selon un second mode de réalisation le troisième interrupteur est constitué par une diode à temps de recouvrement relativement long compte tenu de la période retour du balayage lesdits second et troisième interrupteurs fonctionnant en opposition de phase.

Pour répondre à l'un des buts de l'invention, la source d'alimentation précitée, le second enroulement inductif et le second interrupteur commandé sont galvaniquement isolés du reste du châssis de l'appareil.

Par ailleurs, chaque interrupteur commandé précité est de préférence un interrupteur bi-directionnel commandable dans un sens de conduction. Dans les exemples qui seront décrits plus loin, un interrupteur de ce type est formé par un transistor et une diode à temps de recouvrement court connectée en inverse entre le collecteur et l'émetteur de ce transistor; la base du transistor constituant une entrée de commande de cet interrupteur. On peut aussi envisager de remplacer le transistor par un thyristor ou tout autre dispositif semi-conducteur convenable. L'appellation définie ci-dessus "interrupteur bi-directionnel commandable dans un sens de conduction" signifie simplement qu'un tel interrupteur est susceptible de conduire dans les deux sens si un signal de validation est appliqué sur son entrée de commande mais que cet interrupteur peut conduire spontanément dans l'un des sens sans qu'il soit nécessaire d'appliquer un signal de validation à l'entrée de commande. On verra que l'utilisation de tels interrupteurs simplifie grandement les circuits de pilotage des différents interrupteurs, en mettant à profit les lois de l'électromagnétisme régissant les phénomènes qui se succèdent à l'intérieur du transformateur ligne. Selon un second mode de réalisation, on remplace avantageusement le troisième interrupteur commandé précité par un "interrupteur" d'un autre type ne nécessitant aucun moyen de commande particulier, le pilotage de cet "interrupteur" étant uniquement assuré par les inversions de polarité intervenant périodiquement et automatiquement dans le transformateur ligne du fait de la mise en oeuvre des deux autres interrupteurs commandés.

Ce troisième interrupteur est avantageusement constitué, selon l'invention, par une simple diode à temps de recouvrement relativement long, compte tenu de la période du retour du balayage. En effet, pour une fréquence de recurrence du déviateur de l'ordre de 15 Hz, on est amené à utiliser des diodes dites "rapides" (c'est-à-dire à temps de recouvrement particulièrement faible) dans les circuits mettant en jeu une telle fréquence, pour que la diode se bloque sans retard dès l'apparition d'une tension inverse à ses bornes. On sait que le temps de recouvrement d'une diode est précisément l'intervalle de temps pendant lequel elle conduit en inverse avant de se bloquer lorsqu'on lui applique une tension inverse à ses bornes après l'avoir fait conduire dans le sens direct pendant un temps notable. C'est le temps nécessaire à la recombinaison des porteurs dans la jonction. Or, le troisième interrupteur n'est plus constitué, selon le second mode de réalisation que par une diode "lente".

Cette substitution est possible parce que le temps de conduction à chaque cycle imparti au transistor du troisième interrupteur commandé selon le premier mode de réalisation ne correspond qu'à une demi-période du retour ligne et que ce temps de conduction relativement bref est de l'ordre de grandeur du temps de recouvrement d'une diode du type habituellement destiné au redressement du courant alternatif d'un réseau de distribution à 50 Hz ou 60 Hz.

L'invention sera mieux comprise et d'autres buts, détails et avantages de celle-ci apparaîtront mieux à la lumière de la description qui va suivre de deux modes de réalisation d'un dispositif conforme à l'invention, donnée uniquement à titre d'exemple et faite en référence aux dessins non limitatifs annexés dans lesquels:

— la figure 1 est un schéma de principe d'un premier mode de réalisation d'un dispositif d'alimentation et de déviation horizontale d'un tube cathodique;
— la figure 2 est un chronogramme illustrant le fonctionnement du dispositif de la figure 1;
— la figure 3 est un schéma de principe d'un second mode de réalisation d'un dispositif d'alimentation et de déviation horizontale d'un tube cathodique; et
— la figure 4 est un chronogramme illustrant le fonctionnement du dispositif de la figure 3.

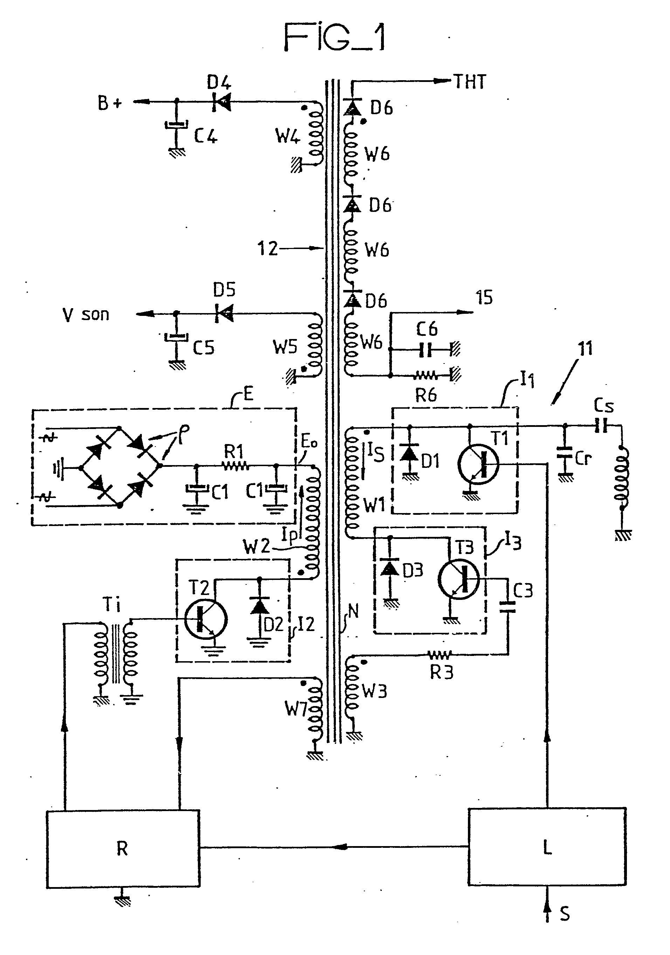

En se reportant à la figure 1, on a représenté notamment un dispositif de déviation horizontale 11 d'un tube cathodique non représenté et comportant un déviateur Ly interconnecté avec deux condensateurs Cs et Cr pour former un circuit oscillant susceptible de fonctionner séquentiellement à deux fréquences d'oscillation différentes pour que le courant traversant le déviateur Ly soit du type "en dents de scie". Plus précisément, l'une des bornes du déviateur Ly est reliée à la masse du châssis, c'est-à-dire à un potentiel de référence, et l'autre borne est reliée à une connexion en série de deux condensateurs Cs et Cr, l'une des bornes du condensateur Cr étant également reliée à la masse. En outre, un interrupteur commandé $I_1$ est connecté en parallèle sur le condensateur Cr. Le condensateur Cs a une capacité notablement plus importante que celle du condensateur Cr. L'interrupteur $I_1$ est du type "bi-directionnel commandable dans un sens de conduction". Comme mentionné précédemment, cet interrupteur peut comporter un transistor T1 dont le collecteur est connecté au point commun des condensateurs Cr et Cs et dont l'émetteur est connecté à la masse (le transistor T1 étant ici du type NPN) et une diode $D_1$ à temps de recouvrement relativement bref, connectée en inverse entre le collecteur et l'émetteur du transistor $T_1$, c'est-à-dire avec sa cathode reliée au collecteur du transistor. La base du transistor $T_1$ constitue l'entrée de commande de l'interrupteur $I_1$ et est reliée à un oscillateur ligne L piloté par des impulsions de synchronisation appliquées sur l'entrée S de cet oscillateur. Un premier enroulement inductif $W_1$ a l'une de ses extrémités reliée au circuit oscillant précité et plus particulièrement au point commun des condensateurs Cs et Cr.

L'enroulement $W_1$ fait partie du transformateur ligne 12 et est couplé par un circuit magnétique constitué par le noyau N de ce transformateur à un second enroulement inductif $W_2$ connecté à une source de tension continue E par l'intermédiaire d'un second interrupteur commandé $I_2$, identique à l'interrupteur $I_1$. Plus précisément, la source de tension continue E est constituée par un pont redresseur P à quatre diodes, relié au secteur et par un filtre Résistance-Capacités ($R_1$, $C_1$) dont la sortie $E_0$ est connectée à l'une des extrémités du bobinage $W_2$; l'autre extrémité de ce bobinage étant reliée à une masse non isolée galvaniquement du secteur par l'intermédiaire de l'interrupteur $I_2$. Cette masse non isolée du secteur est bien entendu rigoureusement isolée de la masse du châssis mentionnée précédemment. Sur la figure 1, les points de masse non isolés du secteur sont symbolisés par des traits horizontaux inscrits dans un triangle, tandis que les points de la masse du châssis sont symbolisés par des traits obliques inscrits dans un rectangle. La base du transistor $T_2$ de l'interrupteur $I_2$ qui constitue l'entrée de commande de cet interrupteur est donc connectée à un enroulement d'un transformateur d'isolement $T_1$ dont l'autre enroulement reçoit les signaux de commande élaborés par une unité de régulation R, connue en soi, laquelle unité reçoit sa tension d'erreur d'un enroulement auxiliaire $W_7$ bobiné sur le noyau N. L'oscillateur ligne L est également connecté à une entrée de l'unité de régulation R pour en synchroniser le fonctionnement.

Selon une caractéristique importante de l'invention, le couplage entre les enroulements $W_1$ et $W_2$ est élevé. Pratiquement, on peut envisager de bobiner ces deux enroulements sur la même "jambe" du transformateur 12. Du reste, dans un mode de réalisation préféré de l'invention, tous les enroulements du transformateur 12, y compris ceux qui seront décrits plus loin, sont bobinés sur la même "jambe" du transformateur ligne, lequel a sensiblement la forme d'un cadre en ferrite à large fenêtre, selon un mode de réalisation habituel d'un transformateur-ligne.

Selon une autre caractéristique importante de l'invention, le dispositif de la figure 1 comporte en outre un troisième interrupteur commandé $I_3$ inséré en série avec l'enroulement $W_1$ entre la masse et le point de connexion de l'enroulement $W_1$ et du circuit oscillant. De préférence, l'interrupteur $I_3$ est inséré comme le montre la figure 1 entre la borne de l'enroulement $W_1$ qui n'est pas connectée au circuit oscillant et la masse du châssis du téléviseur. Si on considère le transistor $T_3$ de l'interrupteur $I_3$, son collecteur est donc relié à l'enroulement $W_1$ et son émetteur est connecté à la masse. La diode $D_3$ à temps de recouvrement relativement bref est branchée entre le collecteur et l'émetteur du transistor $T_3$. La base du transistor $T_3$ qui constitue l'entrée de commande de l'interrupteur $I_3$ est reliée à un enroulement supplémentaire $W_3$, (par l'intermédiaire d'une connexion en série d'une résistance $R_3$ et d'un condensateur $C_3$) bobiné sur le noyau N et dont l'autre extrémité est reliée à la masse. Bien entendu, selon ce qui vient d'être dit précédemment, le couplage entre l'enroulement $W_1$ et l'enroulement $W_3$ est élevé.

Enfin, on remarque, de façon classique, la source THT est constituée par plusieurs enroulements $W_6$ bobinés sur le noyau N et interconnectés en série au moyen de diodes $D_6$. Comme on le verra plus loin, ces éléments fournissent la haute tension du tube cathodique (THT) par redressement pendant le retour ligne. L'un des enroulements $W_6$ est relié à la masse par une connexion en parallèle d'une résistance et d'un condensateur ($R_6$, $C_6$) permettant de prélever à la sortie 15 un signal représentatif du courant débité par la source THT. Un autre enroulement $W_4$ à l'une de ses extrémités connectée à une diode $D_4$ pour fournir une tension stabilisée B+ filtrée par un conducteur $C_4$. Comme on le verra plus loin, cette tension est stabilisée parce que l'enroulement $W_4$ débite uniquement pendant les périodes de retour ligne; la tension crête développée aux bornes de l'enroulement $W_1$ (lequel se comporte alors comme primaire vis à vis de l'enroulement $W_4$) étant stabilisée grâce à l'unité de régulation R. Un autre enroulement W5 est également bobiné sur le noyau N et connecté à une diode $D_5$ qui charge un condensateur de filtrage $C_5$ pour fournir une tension Vson non stabilisée destinée à alimenter les étages BF du téléviseur. Comme on le verra plus loin, cette tension n'est pas stabilisée (elle n'a pas besoin de l'être) parce que l'enroulement $W_5$ ne débite que pendant les périodes aller du balayage.

On remarquera à ce propos que le sens des enroulements du transformateur 12 n'est pas indifférent, les bornes analogues de chaque enroulement étant repérées de façon traditionnelle par un point, sur le schéma de la figure 1. Ainsi, on remarquera que les enroulements $W_1$, $W_3$, $W_4$, $W_6$, et $W_7$ sont tous bobinés à l'inverse des enroulements $W_2$ et $W_5$. Bien entendu, une inversion du sens de bobinage de l'un des enroulements accompagnée d'une inversion des connexions à ses bornes ne change rien. Il ressort simplement de la figure 1 et des sens des enroulements tels qu'indiqués sur cette figure que, si une tension positive, par exemple, est engendrée aux bornes de l'enroulement $W_1$ agissant en tant que primaire, une tension de même polarité sera engendrée aux bornes des enroulements $W_3$, $W_4$, $W_6$ et $W_7$, mais qu'en revanche, une tension négative sera engendrée, par exemple, aux bornes de l'enroulement $W_5$.

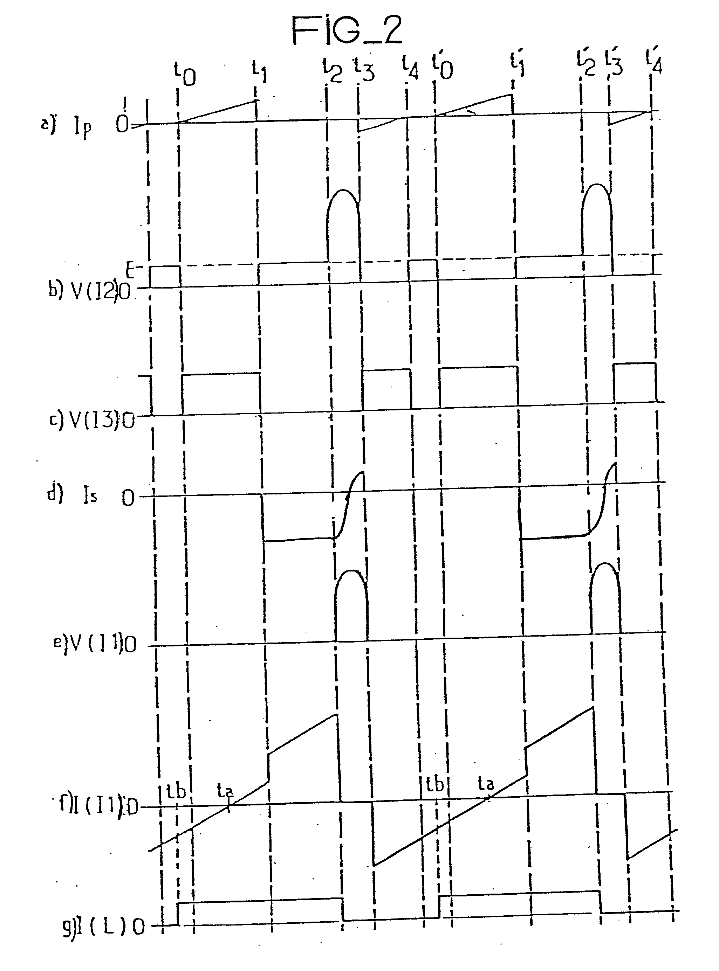

On va maintenant décrire le fonctionnement du dispositif qui vient d'être décrit, en se reportant au chronogramme de la figure 2. Sur ce chronogramme:

— la figure 2a représente le courant Ip dans l'enroulement $W_2$,
— la figure 2b représente la tension V ($I_2$) aux bornes de l'interrupteur $I_2$,
— la figure 2c représente la tension V ($I_3$) aux bornes de l'interrupteur $I_3$,
— la figure 2d représente le courant Is dans l'enroulement $W_1$,
— la figure 2e représente la tension V ($I_1$) aux bornes de l'interrupteur $I_1$,
— la figure 2f représente le courant I ($I_1$) traversant l'interrupteur $I_1$, et
— la figure 2g représente le courant de base I (L) du transistor $T_1$, c'est-à-dire le signal de commande appliqué par l'oscillateur L à l'entrée de commande de l'interrupteur $I_1$.

Par ailleurs, les différents instants caractéristiques du fonctionnement du dispositif de la figure 1 sont repérés en abscisse. Comme le chronogramme de la figure 2 représente sensiblement deux cycles complets de fonctionnement du dispositif, un instant caractéristique peut être indifféremment analysé aux temps $t_i$ ou $t'_i$.

On va d'abord considérer le fonctionnement du déviateur de ligne Ly, en liaison avec les condensateurs Cs et Cr avec lesquels il peut définir deux circuits oscillants de fréquences d'oscillation différente en fonction de l'état de l'interrupteur $I_1$. Le condensateur Cs a une capacité notablement supérieure à celle du condensateur Cr mais l'interrupteur $I_1$ est branché en parallèle sur le condensateur Cr, de sorte que le condensateur Cs est celui qui définit avec l'inductance du déviateur Ly la fréquence d'oscillation pendant une période aller du balayage tandis que la fréquence d'oscillation pendant le retour (plus élevée) est définie par les valeurs de l'inductance du déviateur Ly et de la capacité du condensateur Cr. Pendant l'aller du balayage où le condensateur Cr est court-circuité, le transistor $T_1$ peut être déclenché à un instant non critique, postérieur au début du balayage car le sens du courant dans le déviateur Ly est tel que le circuit oscillant Ly, Cs est refermé par la diode $D_1$ qui conduit sensiblement pendant la première moitié du balayage aller, tant que le courant est "négatif" en considérant la courbe f, c'est-à-dire jusqu'à l'instant $t_a$. Le transistor $T_1$ est mis en préconduction avant cet instant (en tb) par le front montant de l'impulsion délivrée par l'oscillateur ligne L (courbe g) de sorte qu'au blocage automatique de la diode $D_1$, lorsque le courant change de sens dans le déviateur Ly à l'instant $t_a$, le circuit oscillant Ly, Cs peut continuer à osciller du fait que $T_1$ est saturé et ceci jusqu'en $t_2$ (ou $t'_2$), cet instant étant marqué par le front de descente du signal délivré par l'oscillateur ligne L qui initialise le retour du balayage. A cet instant, $t_2$, le transistor $T_1$ se bloque. A ce moment, le circuit oscillant change de fréquence caractéristique puisqu'il est dorénavant essentiellement constitué par le déviateur Ly et le condensateur Cr. Bien entendu, ce condensateur Cr est déchargé au début du retour de balayage. Cependant, le courant dans le déviateur Ly est important de sorte que cette inductance va se décharger dans le condensateur et le courant dans Ly va décroître progressivement (Ly "chargeant" Cr) en développant aux bornes du condensateur Cr une tension "positive", c'est-à-dire bloquant la diode $D_1$; l'énergie de l'induction du déviateur Ly ne pouvant ainsi se transférer que dans le condensateur Cr puisque l'interrupteur $T_1$ est ouvert. De la sorte, le courant dans le déviateur Ly va décroître progressivement jusqu'à s'annuler au milieu du retour ligne. A cet instant précis (le milieu du retour ligne), l'énergie est donc maximum dans le condensateur Cr, lequel va commencer à se décharger dans le déviateur Ly en y faisant circuler un courant de sens contraire, jusqu'à la fin du retour ligne.

A ce moment (instant $t_3$ ou $t'_3$), l'énergie est de nouveau maximum dans le déviateur Ly mais le courant est inversé. Ceci réalise les conditions de l'arrêt automatique du balayage de retour ligne car, lorsque le déviateur Ly va à nouveau amorcer son processus de décharge, cela ne pourra être qu'en chargeant le condensateur Cr avec une polarité "négative" qui entraîne la mise en conduction immédiate de la diode $D_1$, c'est-à-dire la fermeture automatique de l'interrupteur $I_1$. A partir de ce moment, les conditions de fonctionnement et notamment la fréquence d'oscillation du circuit de balayage ligne changent à nouveau puisque le condensateur Cr est de nouveau court-circuité. On amorce aussitôt un nouveau cycle aller avec un circuit oscillant (Ly Cs). On notera qu'à la fin du retour ligne, (instant $t_3$, $t'_3$), le transistor $T_1$ n'a nullement besoin d'être saturé puisque la mise en court-circuit du condensateur Cr est réalisée automatiquement par la mise en conduction de la diode $D_1$. La conduction du transistor $T_1$ n'interviendra que plus tard, au moment du front de montée du signal de l'oscillateur ligne L, pour que le transistor $T_1$ soit prêt à conduire au moment (ta) où le courant dans l'interrupteur $I_1$ va changer de sens (courbe f) c'est-à-dire lorsque la diode $D_1$ ne pourra plus assurer la conduction.

D'autre part, on notera que l'enroulement $W_1$ est en fait connecté, pendant le retour ligne, aux bornes d'une source d'énergie qui est constituée par le circuit oscillant (Ly, Cr); le condensateur Cr développant une tension positive aux bornes de l'enroulement $W_1$, puisque l'interrupteur $I_3$ est fermé, l'autre extrémité de cet enroulement $W_1$ étant ainsi connectée à la masse. Plus précisément, pendant la première partie du retour ligne, l'interrupteur $I_3$ sera fermé par la mise en conduction de la diode $D_3$ en $t_1$ et ensuite, au changement de signe du courant Is dans l'enroulement $W_1$, par le transistor $T_3$ saturé, lequel aura été mis en état de préconduction dès le début du retour ligne grâce à l'enroulement $W_3$ appliquant à sa base une impulsion de tension positive de même allure que celle qui se développe aux bornes de l'interrupteur $I_1$ ouvert (courbe e) puisque l'enroulement W1 se comporte à ce moment comme un "primaire" pour l'enroulement $W_3$.

A la fin du retour ligne, la base du transistor $T_3$ n'est plus alimentée (V($W_3$)=0) et par conséquent, le transistor $T_3$ se bloque à l'instant $t_3$ (courbe d) et toutes les tensions aux bornes de différents enroulements s'inversent brutalement. Par conséquent, la diode $D_2$ est en état de conduire instantanément, ce qui se traduit par l'apparition immédiate d'un courant dans l'enroulement $W_2$ (courbe a, instant $t_3$). Ce point mérite d'être souligné car on remarque, en comparant les courbes d et a, que le système est conçu pour que

les interrupteurs $I_2$ et $I_3$ fonctionnent naturellement en opposition de phase; le changement d'état de l'interrupteur $I_3$ à l'instant $t_3$ entraînant le changement d'état de l'interrupteur $I_2$ par le simple effet des lois de l'électromagnétisme qui veulent que, lorsqu'on coupe un courant circulant dans une bobine, une tension inverse apparaît immédiatement à ses bornes. Par conséquent, la coupure brusque d'un courant notable Is dans l'enroulement $W_1$ (courbe d) à la fin du retour ligne ($T_3$) est instantanément compensée par l'apparition d'un courant $I_p$ dans l'enroulement $W_2$. Il y a donc conservation des ampère-tours dans le circuit magnétique constitué par le noyau N qui, sinon (c'est-à-dire si le courant $I_p$ ne pouvait circuler dans l'enroulement $W_2$ par la non ouverture simultanée de l'interrupteur $I_2$) se dissiperaient sous forme de chaleur et en engendrant des surtensions dans les autres enroulements $W_4$, $W_5$, $W_6$ etc... Autrement dit, le fait qu'un enroulement ($W_2$) soit précisément en état de conduire au moment précis où autre enroulement ($W_1$) est déconnecté, assure le transfert vers l'enroulement $W_2$ de toute l'énergie stockée dans l'enroulement $W_1$ et évite par conséquent que cette énergie ne se répartisse noatmment dans les autres enroulements en créant des surtensions nuisibles dans ceux-ci.

A partir de l'instant $t_3$, l'enroulement $W_1$ joue donc son rôle de primaire mais le courant ("négatif" en considérant la courbe a) qui s'établit brusquement dans cet enroulement à la mise en conduction de la diode $D_2$ est de sens contraire à celui que tend à imposer la source de tension continue E connectée à l'autre borne de cet enroulement. Par conséquent, pendant un certain intervalle de temps $(t_3-t_4)$, le courant dans l'enroulement $W_2$ va décroître en valeur absolue jusqu'à s'annuler et va rester nul jusqu'à la fermeture du transistor $T_2$ dont la commande est engendrée par l'unité de régulation R dont le fonctionnement sera analysé plus loin. De l'instant $t_4$ à la mise en conduction du transistor $t_2$ (instant $t'O$), le transformateur est entièrement relaxé et les tensions aux bornes des enroulements $W_1$, $W_2$ sont nulles. Cet intervalle de temps est plus ou moins long et dépend des signaux de commande engendrés par l'unité de régulation R. A la commande de fermeture du transistor $T_2$, le courant imposé par la source E va croître pendant tout l'intervalle de temps $t'0—t'1$ où les moyens de régulation maintiendront le transistor $T_2$ en conduction. L'énergie stockée pendant ce temps dans l'enroulement $W_2$ dépend donc uniquement de la tension de source E et de l'intervalle de temps $t'0—t'1$ qui pourra varier sous l'action de la régulation, notamment pour compenser d'éventuelles variations de la tension du secteur.

A l'ouverture du transistor $T_2$, le courant est coupé brutalement dans l'enroulement $W_2$ et les conditions sont à nouveau réalisées pour une commutation simultanée et en opposition de phase des commutateurs $I_2$ et $I_3$. En effet, à la coupure brutale du courant dans l'enroulement $W_2$ (courbe a, instant $t'1$) les tensions aux bornes

de l'enroulement $W_1$ et des autres enroulements s'inversent brusquement, ce qui met instantanément la diode $D_3$ en état de conduction (autrement dit, l'interrupteur $I_3$ se ferme automatiquement) et comme cela se produit pendant une période aller du balayage, l'interrupteur $I_1$ est fermé, de sorte qu'un courant peut instantanément traverser l'enroulement $W_1$ dont les bornes sont en court-circuit. Pour les mêmes raisons que précédemment, toute dissipation ou surtension est évitée dans le système par le fait qu'un enroulement ($W_1$) est mis en état de conduire au moment précis où le courant est coupé dans un autre enroulement ($W_2$). Une autre caractéristique importante de l'invention apparaît également clairement à ce stade de la description du fonctionnement, à savoir que l'enroulement $W_1$ n'est jamais court-circuité (interrupteurs $I_3$ et $I_1$) fermés en même temps) lorsque l'enroulement $W_2$ est effectivement connecté à la source d'alimentation E ($I_2$ fermé) ce qui autorise un très bon couplage entreles enroulements $W_1$ et $W_2$ (comme mentionné précédemment, les enroulements $W_1$ et $W_2$ peuvent être bobinés avantageusement sur une même "jambe" du noyau ou circuit magnétique du transformateur ligne) et par conséquent, on est assuré d'un rayonnement très faible du transformateur ligne qui ne risque pas de perturber le fonctionnement des autres éléments du téléviseur et notamment le tube cathodique, très sensible aux champs parasites. Pendant l'intervalle de temps $t'_1$—$t'_2$— dont la durée peut être rendue variable par l'unité de régulation R—l'enroulement $W_1$ a retrouvé son rôle de "primaire" mais n'assure pas d'autres fonctions que de conserver l'énergie dans le noyau N du transformateur ligne au niveau où elle a été prévisionnellement stockée pendant l'intervalle de temps $t'0$—$t'1$.

Après quoi, le front descendant de l'impulsion engendrée par l'oscillateur ligne L commande l'ouverture de l'interrupteur $I_1$ à l'instant $t'_2$ et un nouveau cycle de retour ligne est initialisé, selon le processus précédemment décrit.

On va maintenant décrire le rôle de l'unité de régulation R qui peut être obtenue par tout système d'asservissement, connu en soi, susceptible de faire varier les instants $t_0$ et/ou $t_1$, à chaque cycle. Cette régulation a pour but principal de stabiliser le courant dans le déviateur Ly et on a déjà indiqué plus haut que l'invention permet aussi d'obtenir des tensions stabilisées aussi bien pour fournir la haute tension (THT) nécessaire au fonctionnement du tube cathodique, que pour alimenter les divers circuits électroniques du téléviseur ($W_4$, $D_4$). Pour cela, on pourrait choisir de stabiliser directement le courant traversant le déviateur Ly au moyen d'un asservissement. On préfère cependant prendre comme valeur de réglage la tension crête aux bornes du condensateur Cr pendant le retour ligne, c'est-à-dire lorsque l'interrupteur $I_1$ est ouvert, puisque cette tension est proportionnelle au courant qui traverse le déviateur Ly. Cependant, comme cette tension qui est également celle

què l'on observe aux bornes de l'enroulement $W_1$, peut être importante (de l'ordre de 1 500 volts), on préfère utiliser une tension témoin engendrée aux bornes de l'enroulement $W_7$ (comportant un nombre approprié de tours) comme tension de réglage de l'unité de régulation R puisque pendant le retour ligne, l'enroulement $W_1$ joue le rôle de primaire pour l'enroulement $W_7$ et que la tension développée alors est directement proportionnelle au courant traversant le déviateur Ly. On n'enregistre aucun déphasage entre la tension aux bornes de l'enroulement $W_1$ et la tension résultante aux bornes de l'enroulement $W_7$, pendant le retour ligne, puisque le couplage entre les deux enroulements est élevé. Le système de régulation proprement dit ne sera pas décrit en détail car il est classique. On précisera cependant à titre d'exemple, que la tension crête aux bornes de l'enroulement $W_7$ peut être transformée en tension continue servant à élaborer une tension d'erreur par comparaison avec une tension de référence (donnée par une diode Zenner) au moyen d'un amplificateur différentiel; la sortie de cet amplificateur différentiel associée avec la sortie d'un générateur de rampe piloté par l'oscillateur L commandant un trigger de Schmitt. Le signal de sortie du trigger de Schmitt est bien entendu utilisé pour la commande du transistor $T_2$ par l'intermédiaire du transformateur d'isolement $T_i$.

Un autre aspect du mode de fonctionnement du dispositif selon l'invention concerne la nécessaire ré-injection d'énergie dans le circuit oscillant du déviateur ligne Ly, pour compenser les pertes. Cette ré-injection se produit automatiquement pendant le retour ligne et la différence d'intensité, en valeur absolue, du courant Is entre le début ($t_2$) et la fin ($t_3$) du retour ligne, visible sur la figure 2d représente notamment les pertes compensées dans le circuit oscillant du déviateur.

A ce stade de l'analyse de fonctionnement du dispositif de la figure 1, on peut dégager clairement le concept fondamental de l'invention qui consiste en une utilisation en temps partagé d'un unique composant magnétique; cette utilisation en temps partagé étant rendue possible notamment par l'adjonction de l'interrupteur $I_3$ en sérrie avec l'enroulement $W_1$. On distinguera principalement les phases opératoires suivantes:

— connecter l'enroulement $W_2$ (interrupteur $I_2$ fermé) aux bornes d'une source d'alimentation (E) pendant un temps plus ou moins long au cours de l'aller du balayage pour établir un niveau d'énergie souhaité dans le noyau du transformateur ligne, l'enroulement $W_1$ étant déconnecté pour que ce dernier qui jour alors le rôle de secondaire par rapport à l'enroulement $W_2$ ne se trouve pas en court-circuit franc pendant ce temps, du fait que l'interrupteur $I_1$ est fermé pendant toute la période aller du balayage.
— déconnecter l'enroulement $W_2$ de la source d'alimentation (interrupteur $I_2$ ouvert) lorsque ce niveau d'énergie est atteint et utiliser

l'enroulement $W_1$ pour empêcher la dissipation de l'énergie préalablement stockée, sous forme d'effet Joule, ceci en permettant à un courant de s'établir dans l'enroulement $W_1$ en court-circuit.

— remettre l'enroulement $W_1$ au service du balayage pendant le retour ligne (interrupteur $I_1$ ouvert et interrupteur $I_3$ fermé) où son rôle est indispensable pour entretenir le circuit oscillant et éventuellement utiliser cet enroulement $W_1$ en tant qu'enroulement primaire, pendant cette période, pour alimenter (de façon connue en soi) d'autres enroulements du transformateur ligne, notamment pour fournir différentes tensions d'alimentation du téléviseur ou du tube cathodique.

Enfin, on signalera un dernier avantage important de l'invention, à savoir la possibilité d'obtenir la tension d'alimentation des étages de reproduction du son du téléviseur, à partir du transformateur ligne. En effet, ces étages fonctionnent en classe B et nécessitent donc des pointes de courant importantes. Or, avec le dispositif représenté sur la figure 1, on voit que l'enroulement $W_5$ est bobiné en "sens inverse" des autres enroulements tels que $W_4$ et $W_6$, ce qui signifie que la diode $D_5$ ne sera débloquée et ne pourra charger le condensateur $C_5$ que pendant les périodes aller du balayage. En conséquence, l'énergie nécessaire aux étages de reproduction du son n'est prélevée sur le transformateur ligne qu'en dehors des périodes de retour du balayage. Le fonctionnement en classe B de ces étages de reproduction ne risque donc pas de perturber l'unité de régulation R puisque l'enroulement $W_5$ ne débite que pendant l'aller du balayage où le noyau du transformateur ligne est découplé de la fonction balayage proprement dit, en raison de l'utilisation en temps partagé de ce transformateur ligne, qui n'est possible que grâce à la présence de l'interrupteur $I_3$ au pied de l'enroulement $W_1$; particularité essentielle de l'invention. Le fait que la tension redressée par la diode $D_5$ ne soit pas stabilisée n'est pas critique, s'agissant de l'alimentation de circuits fonctionnant en classe B, il suffit simplement de prévoir un condensateur $C_5$ de capacité suffisante pour assurer un filtrage efficace. Grâce à l'invention, on a donc pour la première fois la possibilité d'alimenter les étages de reproduction du son d'un téléviseur à partir d'un enroulement bobiné sur le transformateur ligne. Comme, d'autre part, l'alimentation du filament du tube cathodique à partir de quelques spires enroulées autour de ce même circuit magnétique ne présente aucune difficulté, on a donc, pour la première fois, la possibilité d'obtenir toutes les tensions nécessaires au fonctionnement du téléviseur à partir d'un seul composant magnétique de puissance, à savoir le transformateur ligne.

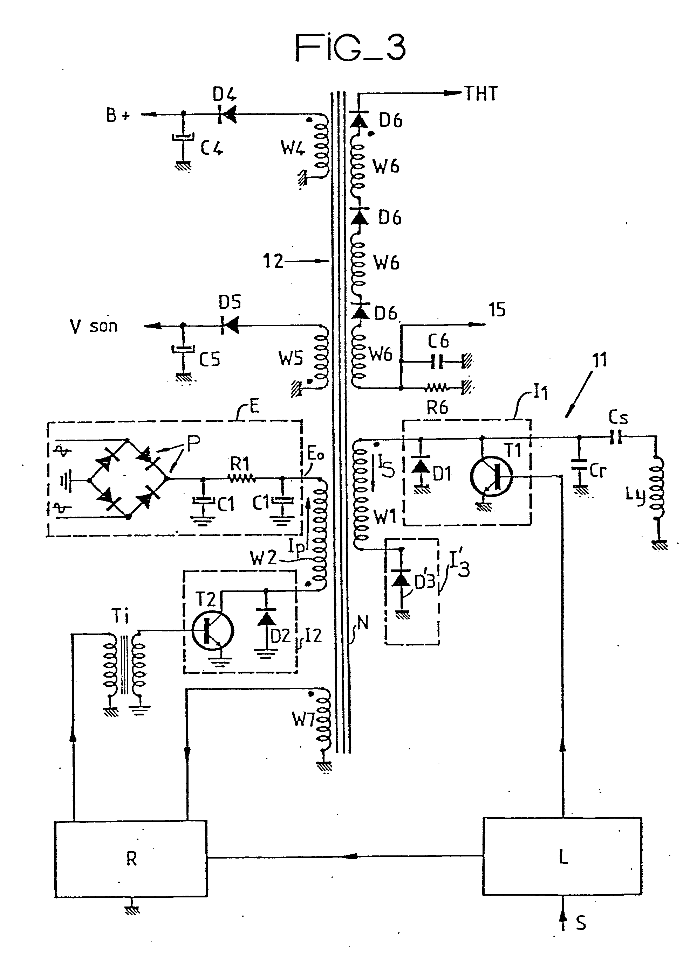

Le second mode de réalisation est représenté à la figure 3 où les composants analogues portent les mêmes références que sur la figure 1.

La seule différence notable réside dans l'agencement du troisième interrupteur $I'_3$ qui remplace l'interrupteur commandé $I_3$ de la figure 1. Comme mentionné plus haut, l'interrupteur $I'_3$ est réduit à une seule diode $D'_3$ à temps de recouvrement relativement long, notamment du type habituellement destiné au redressement à 50 Hz ou 60 Hz. Plus précisément, le temps de retour ligne étant de l'ordre de 10 microsecondes, il suffit que le temps de recouvrement de cette diode soit supérieur à 5 microsecondes. La cathode de la diode $D'_3$ est reliée à l'enroulement $W_1$ et son anode est reliée à la masse du châssis. Bien entendu, l'enroulement de commande $W_3$ et la liaison ($R_3$, $C_3$) décrite en référence à la figure 1 sont supprimés puisque le troisième interrupteur $I'_3$ ne comporte plus de transistor.

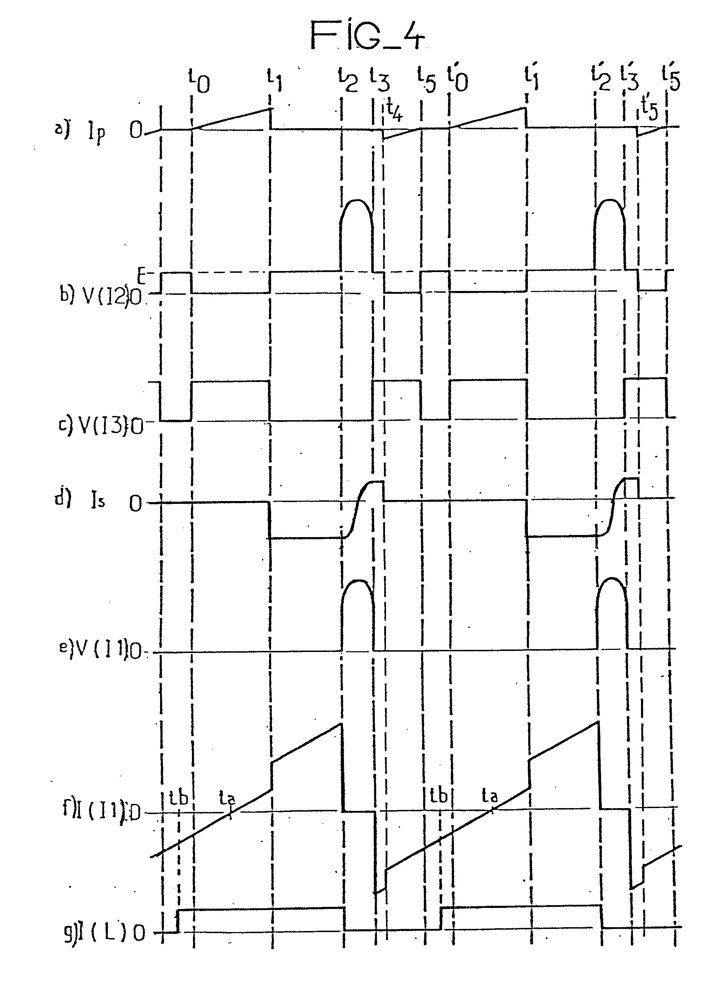

Le fonctionnement de ce second mode de réalisation va être analysé en référence au chronogramme de la figure 4. Sur le chronogramme:

— la figure 4a représente le courant $I_p$ dans l'enroulement $W_2$,
— la figure 4b représente la tension V ($I_2$) aux bornes de l'interrupteur $I_2$;
— la figure 4c représente la tension V ($I'3$) aux bornes de l'interrupteur $I'_3$;
— la figure 4d représente le courant Is dans l'enroulement $W_1$;
— la figure 4e représente la tension V ($I_1$) aux bornes de l'interrupteur $I_1$;
— la figure 4f représente le courant I ($I_1$) traversant l'interrupteur $I_1$, et
— la figure 4g représente le courant de base I (L) du transistor $T_1$, c'est-à-dire le signal de commande appliqué par l'oscillateur L à l'entrée de commande de l'interrupteur $I_1$.

Par ailleurs, les différents instants caractéristiques du fonctionnement du dispositif de la figure 3 sont repérés en abscisse. Comme le chronogramme de la figure 4 représente sensiblement deux cycles complets de fonctionnement du dispositif, un instant caractéristique peut être indifféremment analysé aux temps $t_i$ ou $t'_i$.

On va d'abord considérer le fonctionnement du déviateur de ligne Ly, en liaison avec les condensateurs Cs et Cr avec lesquels il peut définir deux circuits oscillants de fréquences d'oscillation différente en fonction de l'état de l'interrupteur $I_1$. Le condensateur Cs a une capacité notablement supérieure à celle du condensateur Cr mais l'interrupteur $I_1$ est branché en parallèle sur le condensateur Cr, de sorte que le condensateur Cs est celui qui définit avec l'inductance du déviateur Ly la fréquence d'oscillation pendant une période aller du balayage tandis que la fréquence d'oscillation pendant le retour (plus élevée) est définie par les valeurs de l'inductance du déviateur Ly et de la capacité du condensateur Cr. Pendant l'aller du balayage où le condensateur Cr est court-circuité, le transistor $T_1$ peut être déclenché à un instant non critique, postérieur au début du balayage car le sens du courant dans le déviateur Ly est tel que le circuit oscillant Ly, Cs est refermé

par la diode $D_1$ qui conduit sensiblement pendant la première moitié du balayage aller, tant que le courant est "négatif" en considérant la courbe f, c'est-à-dire jusqu'à l'instant $t_a$. Le transistor $T_1$ est mis en préconduction avant cet instant (en tb) par le front montant de l'impulsion délivrée par l'oscillateur ligne L (courbe g) de sorte qu'au blocage automatique de la diode $D_1$, lorsque le courant change de sens dans le déviateur Ly à l'instant $t_a$, le circuit oscillant Ly, Cs peut continuer à osciller du fait que $T_1$ est saturé et ceci jusqu'en $t_2$ (ou $t'_2$), cet instant étant marqué par le front de descente du signal délivré par l'oscillateur ligne L qui initialise le retour du balayage. A cet instant, $t_2$, le transistor $T_1$ se bloque. A ce moment, le circuit oscillant change de fréquence caractéristique puisqu'il est dorénavant essentiellement constitué par le déviateur Ly et le condensateur Cr. Bien entendu, ce condensateur Cr est déchargé au début du retour de balayage. Cependant, le courant dans le déviateur Ly est important de sorte que cette inductance va se décharger dans le condensateur et le courant dans Ly va décroître progressivement (Ly "chargeant" Cr) en développant aux bornes du condensateur Cr une tension "positive", c'est-à-dire bloquant la diode $D_1$; l'énergie de l'induction du déviateur Ly ne pouvant ainsi se transférer que dans le condensateur Cr puisque l'interrupteur $T_1$ est ouvert. De la sorte, le courant dans le déviateur Ly va décroître progressivement jusqu'à s'annuler au milieu du retour ligne. A cet instant, précis (le milieu du retour ligne), l'énergie est donc maximum dans le condensateur Cr, lequel va commencer à se décharger dans le déviateur Ly en y faisant circuler un courant de sens contraire, jusqu'à la fin du retour ligne.

A ce moment, (instant $t_3$ ou $t'_3$), l'énergie est de nouveau maximum dans le déviateur Ly mais le courant est inversé. Ceci réalise les conditions de l'arrêt automatique du balayage du retour ligne car, lorsque le déviateur Ly va à nouveau amorcer son processus de décharge, cela ne pourra être qu'en chargeant le condensateur Cr avec une polarité "négative" qui entraîne la mise en condition immédiate de la diode $D_1$, c'est-à-dire la fermeture automatique de l'interrupteur $l_1$. A partir de ce moment, les conditions de fonctionnement et notamment la fréquence d'oscillation du circuit de balayage ligne changent à nouveau puisque le condensateur Cr est de nouveau court-circuité. On amorce aussitôt un nouveau cycle aller avec un circuit oscillant (Ly, Cs). On notera qu'à la fin du retour ligne, (instant $t_3$, $t'_3$), le transistor $T_1$ n'a nullement besoin d'être saturé puisque la mise en court-circuit du condensateur Cr est réalisée automatiquement par la mise en conduction de la diode $D_1$. La conduction du transistor $T_1$ n'interviendra que plus tard, au moment du front de montée du signal de l'oscillateur ligne L, pour que le transistor $T_1$ soit prêt à conduire au moment (ta) où le courant dans l'interrupteur $l_1$ va changer de sens (courbe f) c'est-à-dire lorsque la diode $D_1$ ne pourra plus assurer la conduction.

D'autre part, on notera que l'enroulement $W_1$ est en fait connecté, pendant le retour ligne, aux bornes d'une source d'énergie qui est constituée par le circuit oscillant (Ly, Cr); le condensateur Cr développant une tension positive aux bornes de l'enroulement $W_1$, puisque l'interrupteur $l'_3$ est fermé, l'autre extrémité de cet enroulement $W_1$ étant ainsi connectée à la masse. Plus précisément, pendant la première partie du retour ligne, l'interrupteur $l'3$ est fermé par la mise en conduction normale de la diode $D'3$ en $t_1$ et il reste fermé après le changement de signe du courant Is dans l'enroulement $W_1$, pour la simple raison qu'on a utilisé une diode $D'3$ à temps de recouvrement relativement long. Sur la figure 4, le temps de recouvrement est l'intervalle de temps entre le milieu du retour ligne (milieu de l'intervalle $t_2$—$t_3$) et l'instant $t_4$, lequel peut varier d'un circuit à l'autre (en fonction de la caractéristique de la diode) sans inconvénient, pourvu que l'instant $t_4$ soit toujours postérieur à la fin du retour ligne $t_3$. A ce moment, l'interrupteur $l_1$ se ferme et l'enroulement $W_1$ est en court-circuit jusqu'à l'instant $t_4$. Donc, pendant l'intervalle ($t_3$—$t_4$), la valeur du courant $l_s$ ne change pas.

A l'instant $t_4$, la diode cesse de conduire "en recouvrement" (courbe d) et toutes les tensions aux bornes des différents enroulements s'inversent brutalement. Par conséquent, la diode $D_2$ est en état de conduire instantanément, ce qui se traduit par l'apparition immédiate d'un courant dans l'enroulement $W_2$ (courbe a, instant $t_4$). Ce point mérite d'être souligné car on remarque, en comparant les coubres d et a que le système est conçu pour que les interrupteur $l_2$ et $l'_3$ fonctionnenet naturellement en opposition de phase; le changement d'état de l'interrupteur $l'_3$ à l'instant $t_4$ entraînant le changement d'état de l'interrupteur $l_2$ par le simple effet des lois de l'électromagnétisme qui veulent que, lorsqu'on coupe un courant circulant dans une bobine, une tension inverse apparaît immédiatement à ses bornes. Par conséquent, la coupure brusque d'un courant notable Is dans l'enroulement $W_2$ (courbe d) au blocage de la diode $D'3(t_4)$ est instantanément compensée par l'apparition d'un courant $l_p$ dans l'enroulement $W_2$. Il y a donc conservation des ampère-tours dans le circuit magnétique constitué par le noyau N qui, sinon (c'est-à-dire si le courant $l_p$ ne pouvait circuler dans l'enroulement $W_2$ par la non ouverture simultanée de l'interrupteur $l_2$) se dissiperaient sous forme de chaleur et en engendrant des surtensions dans les autres enroulements $W_4$, $W_5$, $W_6$ etc. . . Autrement dit, le fait qu'un enroulement ($W_2$) soit précisément en état de conduire au moment précis où un autre enroulement ($W_1$) est déconnecté, assure le transfert vers l'enroulement $W_2$ de toute l'énergie stockée dans l'enroulement $W_1$ et évite par conséquent que cette énergie ne se répartisse notamment dans les autres enroulements en créant des surtensions nuisibles dans ceux-ci.

A partir de l'instant $t_4$, l'enroulement $W_1$ joue donc son rôle de primaire mais le courant ("négatif" en considérant la courbe a) qui s'établit brusquement dans cet enroulement à la mise en conduction de la diode $D_2$ est de sens contraire à celui que tend à imposer la source de tension continue E connectée à l'autre borne de cet enroulement. Par conséquent, pendant un certain intervalle de temps $(t_4—t_5)$, le courant dans l'enroulement $W_2$ va décroître en valeur absolue jusqu'à s'annuler et va rester nul jusqu'à la fermeture du transistor $T_2$ dont la commande est engendrée par l'unité de régulation R. De l'instant $t_5$ à la mise en conduction du transistor $t_2$ (instant t'0), le transformateur est entièrement relaxé et les tensions aux bornes des enroulements $W_1$, $W_2$ sont nulles. Cet intervalle de temps est plus ou moins long et dépend des signaux de commande engendrés par l'unité de régulation R. A la commande de fermeture du transistor $T_2$, le courant imposé par la source Eva croître pendant tout l'intervalle de temps $t'_0—t'_1$ où les moyens de régulation maintiendront le transistor $T_2$ en conduction. L'énergie stockée pendant ce temps dans l'enroulement $W_2$ dépend donc uniquement de la tension de source E et de l'intervalle de temps $t'_0—t'_1$ qui pourra varier sous l'action de la régulation, notamment pour compenser d'éventuelles variations de la tension du secteur. A l'ouverture du transistor $T_2$, le courant est coupé brutalement dans l'enroulement $W_2$ et les conditions sont à nouveau réalisées pour une commutation simultanée et en opposition de phase des commutateurs $I_2$ et $I'_3$. En effet, à la coupure brutale du courant dans l'enroulement $W_2$ (courbe a, instant $t'_1$), les tensions aux bornes de l'enroulement $W_1$ et des autres enroulements s'inversent brusquement, ce qui met instantanément la diode $D'_3$ en état de conduction (autrement dit, l'interrupteur $I'_3$ se ferme automatiquement) et comme cela se produit pendant une période aller du balayage, l'interrupteur $I_1$ est fermé, de sorte qu'un courant peut instantanément traverser l'enroulement $W_1$ dont les bornes sont en court-circuit. Pour les mêmes raisons que précédemment, toute dissipation ou surtension est évitée dans le système par le fait qu'un enroulement $(W_1)$ est mis en état de conduire au moment précis où le courant est coupé dans un autre enroulement $(W_2)$. Une autre caractéristique importante apparaît également clairement à ce stade de la description du fonctionnement, à savoir que l'enroulement $W_1$ n'est jamais court-circuité (interrupteurs $I'_3$ et $I_1$ fermés en même temps, lorsque l'enroulement $W_2$ est effectivement connecté à la source d'alimentation E ($I_2$ fermé) ce qui autorise un très bon couplage entre les enroulements $W_1$ et $W_2$ (comme mentionné précédemment, les enroulements $W_1$ et $W_2$ peuvent être bobinés avantageusement sur une même "jambe" du noyau ou circuit magnétique du transformateur ligne) et par conséquent, on est assuré d'un rayonnement très faible du transformateur ligne qui ne risque pas de perturber le fonctionnement des autres éléments du téléviseur et notamment le tube cathodique, très sensible aux champs parasites. Pendant l'intervalle de temps $t'_1—t'_2$—dont la durée peut être rendue variable par l'unité de régulation R—l'enroulement $W_1$ a retrouvé son rôle de "primaire" mais n'assure pas d'autres fonctions que de conserver l'énergie dans le noyau N du transformateur ligne au niveau où elle a été prévisionnellement stockée pendant l'intervalle de temps t'0—t'1.

Après quoi, le front descendant de l'impulsion engendrée par l'oscillateur ligne L commande l'ouverture de l'interrupteur $I_1$ à l'instant $t'_2$ et un nouveau cycle de retour ligne est initialisé, selon le processus précédemment décrit.

Bien entendu, l'invention n'est nullement limitée aux modes de réalisation du dispositif qui viennent d'être décrits. En particulier, les enroulements $W_1$ et $W_2$ sont représentés comme étant galvaniquement indépendants. Ceci est bien entendu la condition d'isolement galvanique du châssis du téléviseur par rapport au secteur. Cependant, si on estime que cet isolement galvanique n'est pas indispensable, il est possible de combiner le bobinage des enroulements $W_1$ et $W_2$ en une structure d'auto-transformateur. A la limite, si on cherche à simplifier encore le circuit en adoptant un rapport de transformation égal à 1 entre les deux enroulements $W_1$ et $W_2$, alors, il est possible de faire l'économie d'un bobinage, les deux enroulements $W_1$ et $W_2$ étant combinés: c'est dire que l'invention couvre tous les équivalents techniques des moyens mis en jeu si ceux-ci le sont dans le cadre des revendications qui suivent.

**Revendications**

1. Procédé d'entretien d'un circuit électrique oscillant à deux fréquences d'oscillation commutables séquentiellement, pour le balayage ligne d'un tube cathodique, du type consistant à induire de l'énergie d'entretien dans un premier enroulement $(W_1)$ inductif connecté audit circuit électrique oscillant au point commun de deux condensateurs $(C_r, C_s)$ de celui-ci et à court-circuiter périodiquement l'un $(C_r)$ desdits condensateurs, la fréquence d'oscillation la plus faible s'établissant pendant une période aller dudit balayage lorsque ce condensateur est court-circuité et la fréquence d'oscillation la plus élevée s'établissant pendant une période retour dudit balayage lorsque ce condensateur n'est pas court-circuité, caractérisé en ce qu'il consiste, au moyen d'un second enroulement $(W_2)$ inductif susceptible d'être branché à une source de tension continue (E) et couplé audit premier enroulement $(W_1)$ avec un facteur de couplage électromagnétique élevé, au moyen d'un circuit magnétique (N):

— à interconnecter ledit second enroulement $(W_2)$ aux bornes de ladite source de tension continue (E) au cours de chaque période aller précitée jusqu'à établir un niveau d'énergie prédéterminé dans ledit circuit magnétique, en maintenant ledit premier enroulement $(W_1)$ déconnecté dudit circuit électrique oscillant:

— à déconnecter ledit second enroulement ($W_2$) de ladite source de tension lorsque ledit niveau d'énergie est atteint en connectant simultanément ledit premier enroulement ($W_1$) aux bornes dudit condensateur (Cr) court-circuité, jusqu'à la fin de ladite période aller si ledit niveau d'énergie est atteint avant celle-ci,

— a ouvrir le court-circuit aux bornes dudit condensateur pendant toute la période retour en maintenant ledit premier enroulement ($W_1$) connecté audit circuit électrique oscillant pendant au moins ladite période retour, et

— à déconnecter au début de la période aller du balayage ledit premier enroulement ($W_1$) dudit circuit électrique oscillant et à connecter simultanément ledit second enroulement ($W_2$) aux bornes de ladite source de tension continue (E), le premier enroulement ($W_1$) ne pouvant être court-circuité.

2. Procédé selon la revendication 1, caractérisé en ce qu'on ne connecte ledit second enroulement ($W_2$) aux bornes de ladite source de tension continue (E) que pendant le début de la période aller suivant jusqu'à atteindre un niveau d'énergie sensiblement nul dans ledit circuit magnétique (N).

3. Dispositif de déviation horizontale d'un tube cathodique, du type comportant:

— un circuit oscillant relié à un premier enroulement inductif ($W_1$) et comprenant le déviateur (Ly) dudit tube cathodique ainsi que deux condensateurs (Cr, Cs) l'un desdits condensateurs (Cr) étant connecté entre un point de connexion dudit premier enroulement audit circuit oscillant et un point à un potentiel de référence,

— un premier interrupteur commandé ($I_1$) connecté aux bornes de ce condensateur (Cr) pour le court-circuiter pendant chaque période aller de balayage et le mettre en service dans ledit circuit oscillant pendant chaque période retour de balayage, et

— un second enroulement inductif ($W_2$) couplé au premier enroulement par un circuit magnétique et connecté à une source de tension continue (E) par l'intermédiaire d'un second interrupteur commandé ($I_2$), le premier enroulement ne pouvant jamais être court-circuité quand le second enroulement est connecté à la source de tension, les interrupteurs commandés étant du type actif à commutation forcée dans un premier sens de conduction et à commutation naturelle dans le sens opposé; ledit dispositif étant caractérisé en ce que le couplage magnétique entre lesdits premier ($W_1$) et second ($W_2$) enroulements est élevé et en ce qu'il comporte en outre un troisième interrupteur commandé ($I_3$) du même type que les deux premiers inséré en série avec ledit premier enroulemente ($W_1$) entre ledit point à un potentiel de référence et ledit point de connexion, les second et troisième interrupteurs (I 2 et I 3) fonctionnant en opposition de phase.

4. Dispositif de déviation horizontale d'un tube cathodique, du type comportant:

— un circuit oscillant relié à un premier enroulement inductif ($W_1$) et comprenant, le déviateur (Ly) dudit tube cathodique ainsi que deux condensateurs (Cr, Cs) l'un desdits condensateurs (Cr) étant connecté entre un point de connexion dudit premier enroulement audit circuit oscillant et un point à un potentiel de référence,

— un premier interrupteur commandé ($I_1$) connecté aux bornes de ce condensateur (Cr) pour le court-circuiter pendant chaque période aller de balayage et le mettre en service dans ledit circuit oscillant pendant chaque période retour de balayage, et

— un second enroulement inductif ($W_2$) couplé au premier enroulement par un circuit magnétique et connecté à une source de tension continue (E) par l'intermédiaire d'un second interrupteur commandé ($I_2$), le premier enroulement ne pouvant jamais être court-circuité quand le second enroulement est connecté à la source de tension, les interrupteurs commandés sont du type actif à commutation forcée dans un premier sens de conduction et à commutation naturelle dans le sens opposé; ledit dispositif étant caractérisé en ce que le couplage magnétique entre lesdits premier ($W_1$) et second ($W_2$) enroulements est élevé et en ce qu'il comporte en outre un troisième circuit interrupteur ($I'_3$), constitué par une diode ($D'3$) à temps de recouvrement relativement long compte tenu de la période retour du balayage inséré en série avec ledit premier enroulement ($W_1$) entre ledit point à un potentiel de référence et ledit point de connexion, les second et troisième interrupteurs (I 2 et I'3) fonctionnant en opposition de phase.

5. Dispositif selon la revendication 4, caractérisé en ce que ladite diode ($D'_3$) est branchée entre une borne dudit premier enroulement ($W_1$) et un point audit potentiel de référence.

6. Dispositif selon la revendication 5, caractérisé en ce que cette diode ($D'_3$) a un temps de recouvrement au moins égal à la moitié de la période de retour de balayage dudit déviateur (Ly).

7. Dispositif selon l'une quelconque des revendications 4 à 6, caractérisé en ce que cette diode ($D'_3$) a un temps de recouvrement supérieur à 5 microsecondes.

8. Dispositif selon l'une des revendications 4 à 7, caractérisé en ce que cette diode ($D'_3$) est d'un type habituellement destiné au redressement du courant alternatif d'un réseau de distribution à 50 Hz ou 60 Hz.

9. Dispositif selon la revendication 3 caractérisé en ce que ledit troisième interrupteur commandé ($I_3$) est branché entre une borne dudit premier enroulement ($W_1$) et un point audit potentiel de référence et que des moyens de pilotage comprennent notamment un enroulement supplémentaire (W₃) bobiné sur ledit circuit magnétique, dont une extrémité est connectée à un point audit potentiel de référence, et (T₃) dudit troisième interrupteur; le couplage entre ledit premier enroulement (W₁) et ledit enroulement supplémentaire (W₃) étant élevé.

10. Dispositif selon l'une des revendications 3 à 9, caractérisé en ce que les deux premiers interrupteurs commandés sont constitués d'un transistor (T₁, T₂) et d'une diode rapide (D₁, D₂) connectée en inverse entre le collecteur et l'émetteur dudit transistor la base du transistor constituant une entrée de commande dudit interrupteur.

11. Dispositif selon l'une des revendications 3 à 10, caractérisé en ce que ledit second interrupteur (I₂) commandé est piloté par un système de régulation (R) du courant dans ledit déviateur aux retours du balayage.

12. Dispositif selon la revendication 11, caractérisé en ce qu'il comporte en outre au moins un enroulement d'alimentation stabilisée (W₄, W₆) couplé magnétiquement audit premier enroulement et associé à un redresseur, le sens de bobinage de cet enroulement et le sens de branchement de ce redresseur étant choisis pour que ce dernier ne soit actif que pendant ladite période de retour du balayage.

13. Dispositif selon l'une des revendications 3 à 12, caractérisé en ce qu'il comporte en outre au moins un enroulement d'alimentation non stabilisée (W₅) couplé magnétiquement audit second enroulement et associé à un redresseur, le sens de bobinage de cet enroulement et le sens de branchement de ce redresseur étant choisis pour que ce dernier ne soit actif que pendant ladite période aller du balayage.

**Patentansprüche**

1. Verfahren zum Betreiben eines elektrischen Schwingkreises mit zwei aufeinanderfolgend umschaltbaren Schwingfrequenzen für die Zeilenabtastung einer Kathodenstrahlröhre, demgemäß Betriebsenergie in eine erste induktive Wicklung (W₁) induziert wird, die an den elektrischen Schwingkreis über den gemeinsamen Punkt zweier seiner Kondensatoren (Cr, Cs) angeschlossen ist, dann periodisch einer dieser Kondensatoren (Cr) kurzgeschlossen wird, wobei sich die niedrigere Schwingfrequenz während einer Abtastperiode einstellt, wenn dieser Kondensator kurzgeschlossen ist, wogegen sich die höhere Schwingfrequenz während einer Strahlrücklaufperiode einstellt, wenn dieser Kondensator nicht kurzgeschlossen ist, dadurch gekennzeichnet, daß mithilfe einer zweiten induktiven Wicklung (W₂), die an einer Gleichspannungsquelle (E) angeschlossen ist und mit einem hohen magnetischen Koppelfaktor an die erste Wicklung (W₁) über einen Magnetkreis (N) angekoppelt werden kann,

— die zweite Wicklung (W₂) an die Klemmen der Gleichspannungsquelle (E) während jeder Abtastperiode angeschlossen wird, bis ein vorgegebenes Energieniveau in dem Magnetkreis erreicht wird, wobei die erste Wicklung (W₁) von dem elektrischen Schwingkreis abgetrennt bleibt,

— die zweite Wicklung (W₂) von der Spannungsquelle abgetrennt wird, wenn dieses Energieniveau erreicht ist, wobei gleichzeitig die erste Wicklung (W₁) an die Klemmen des kurzgeschlossenen Kondensators (Cr) angelegt wird und es bis zum Ende der Abtastperiode bleibt, sofern dieses Energieniveau vor diesem Ende erreicht wurde,

— der Kurzschluß zwischen den Klemmen des Kondensators während der ganzen Strahlrücklaufperiode aufgehoben wird und zugleich die erste Wicklung (W₁) zumindest während der Strahlrücklaufperiode an den elektrischen Schwingkreis angeschlossen gehalten wird, und

— zu Beginn der Abtastperiode die erste Wicklung (W₁) von dem elektrischen Schwingkreis abgetrennt wird und zugleich die zweite Wicklung (W₂) an die Klemmen der Gleichspannungsquelle (E) angeschlossen wird, wobei die erste Wicklung (W₁) nicht kurzgeschlossen werden kann.

2. Verfahren nach Anspruch 1, dadurch gekennzeichnet, daß die zweite Wicklung (W₂) an die Klemmen der Gleichspannungsquelle (E) nur während des Beginns der nächstfolgenden Abtastperiode angeschlossen wird, bis ein Energieniveau von im wesentlichen Null in dem Magnetkreis (N) erreicht wird.

3. Vorrichtung zur Horizontalablenkung einer Kathodenstrahlröhre mit

— einem Schwingkreis, der an eine erste induktive Wicklung (W₁) angeschlossen ist und die Ablenkspule (Ly) der Kathodenstrahlröhre sowie zwei Kondensatoren (Cr, Cs) umfaßt, von denen einer (Cr) zwischen einen Verbindungspunkt der ersten Wicklung mit dem Schwingkreis und einen Punkt eingefügt ist, der auf einem Bezugspotential liegt,

— einem ersten gesteuerten Unterbrecher (I₁), der an die Klemmen dieses Kondensators (Cr) angeschlossen ist, um ihn während jeder Abtastperiode kurzzuschließen und ihn in dem Schwingkreis während jeder Strahlrücklaufperiode wirksam werden zu lassen, und

— mit einer zweiten induktiven Wicklung (W₂), die an die erste Wicklung über einen Magnetkreis angekoppelt ist und an eine Gleichspannungsquelle (E) über einen zweiten gesteuerten Unterbrecher (I₂) angeschlossen ist, wobei die erste Wicklung nie dann kurzgeschlossen sein kann, wenn die zweiten Wicklung an die Spannungsquelle angeschlossen ist, und die gesteuerten Unterbrecher aktive Unterbrecher mit erzwungener Umschaltung in eine erste Leitrichtung und natürlicher Umschaltung in die Gegenrichtung sind, dadurch gekennzeichnet, daß die magnetische Kopplung

zwischen der ersten ($W_1$) und der zweiten Wicklung ($W_2$) eine starke Kopplung ist und daß sie außerdem einen dritten gesteuerten Unterbrecher ($I_3$) vom selben Typ wie die beiden zuerst genannten Unterbrecher aufweist, der in Reihe mit der ersten Wicklung ($W_1$) zwischen dem Bezugspotentialpunkt und dem gennanten Verbindungspunkt eingefügt ist, wobei der zweite und der dritte Unterbrecher ($I_2$ und $I_3$) in Gegenphase betrieben werden.

4. Vorrichtung zur Horizontalablenkung einer Kathodenstrahlröhre mit

— einem Schwingkreis, der an eine erste induktive Wicklung ($W_1$) angeschlossen ist und die Ablenkspule (Ly) der Kathodenstrahlröhre sowie zwei Kondensatoren (Cr, Cs) umfaßt, von denen einer (Cr) zwischen einem Verbindungspunkt der ersten Wicklung und des Schwingkreises und einem Bezugspotentialpunkt angeschlossen ist,
— einem ersten gesteuerten Unterbrecher ($I_1$), der an die Klemmen dieses Kondensators (Cr) angeschlossen ist, um ihn währen jeder Abtastperiode kurzzuschließen und um ihn währen jeder Strahlrücklaufperiode im dem Schwingkreis wirksam werden zu lassen, und
— einer zweiten induktiven Wicklung ($W_2$), die an die erste Wicklung über einen Magnetkreis angekoppelt ist und an eine Gleichspannungsquelle (E) über einen zweiten gesteuerten Unterbrecher ($I_2$) angeschlossen ist, wobei die erste Wicklung dann niemals kurzgeschlossen sein kann, wenn die zweite Wicklung an die Spannungsquelle angeschlossen ist, und wobei die gesteuerten Unterbrecher vom aktiven Typ mit erzwungener Umschaltung in eine erste Leitrichtung und natürlicher Umschaltung in die Gegenrichtung sind, dadurch gekennzeichnet, daß die magnetische Kopplung zwischen den beiden Wicklungen ($W_1$, $W_2$) stark ist und daß die außerdem einen dritten Unterbrecherschaltkreis ($I'_3$) aufweist, der aus einer Diode (D'3) mit verhältnismäßig langer Erholzeit im Vergleich zur Strahlrücklaufperiode besteht und der in Reihe mit der ersten Wicklung ($W_1$) zwischen dem Bezugspotentialpunkt und dem genannten Verbindungspunkt eingefügt ist, wobei der zweite und der dritte Unterbrecher ($I_2$ und $I'3$) in Gegenphase betrieben werden.

5. Vorrichtung nach Anspruch 4, dadurch gekennzeichnet, daß diese Diode (D'3) zwischen eine Klemme der ersten Wicklung ($W_1$) und den genannten Bezugspotentialpunkt eingefügt ist.

6. Vorrichtung nach Anspruch 5, dadurch gekennzeichnet, daß diese Diode (D'3) eine Überdeckungszeit aufweist, die mindestens gleich der Hälfte der Strahlrücklaufperiode der Ablenkspule (Ly) ist.

7. Vorrichtung nach einem beliebigen der Ansprüche 4 bis 6, dadurch gekennzeichnet, daß diese Diode (D'3) eine Überdeckungszeit hat, die größer als 5 Mikrosekunden ist.

8. Vorrichtung nach einem der Ansprüche 4 bis 7, dadurch gekennzeichnet, daß diese Diode (D'3) von dem Typ ist, wie er regelmäßig zur Gleichrichtung von Wechselstrom von 50 Hz oder 60 Hz in einem Verteilernetz verwendet wird.

9. Vorrichtung nach Anspruch 3, dadurch gekennzeichnet, daß der dritte gesteuerte Unterbrecher ($I_3$) zwischen eine Klemme der erste Wicklung ($W_1$) und den Bezugspotentialpunkt angeschlossen ist und daß Steuermittel insbesondere eine weitere Wicklung ($W_3$) aufweisen, die auf den Magnetkreis aufgewickelt ist und deren eines Ende an einen Punkt mit dem Bezugspotential angeschlossen ist und deren anderes Ende an den Steuereingang ($T_3$) des dritten Unterbrechers angeschlossen ist, wobei die Kopplung zwischen der ersten Wicklung ($W_1$) und der zusätzlichen Wicklung ($W_3$) stark ist.

10. Vorrichtung nach einem der Ansprüche 3 bis 9, dadurch gekennzeichnet, daß die beiden ersten gesteuerten Unterbrecher aus Transistoren ($T_1$, $T_2$) und einer schnellen Diode ($D_1$, $D_2$) bestehen, wobei die Dioden in Umkehrrichtung zwischen den Kollektor und den Emitter des betreffenden Transistors angeschlossen sind, dessen Basis einen Steuereingang des Unterbrechers bildet.

11. Vorrichtung nach einem der Ansprüche 3 bis 10, dadurch gekennzeichnet, daß der zweite gesteuerte Unterbrecher ($I_2$) von einem Regelsystem (R) für den Strom in der Ablenkspule während der Strahlrücklaufperioden gesteuert wird.

12. Vorrichtung nach Anspruch 11, dadurch gekennzeichnet, daß sie außerdem mindestens eine Wicklung ($W_4$, $W_6$) für eine stabilisierte Stromversorgung aufweist, wobei diese Wicklung magnetisch mit der ersten Wicklung gekoppelt und einem Gleichrichter zugeordnet ist und wobei der Wicklungssinn dieser Wicklung und die Polarisierung diese Gleichrichters so gewählt sind, daß dieser Gleichrichter nur während der Strahlrücklaufperiode aktiv ist.

13. Vorrichtung nach einem der Ansprüche 3 bis 12, dadurch gekennzeichnet, daß sie außerdem mindestens eine Wicklung ($W_5$) für eine nicht stabilisierte Stromversorgung aufweist, wobei diese Wicklung magnetisch mit der zweiten Wicklung gekoppelt und einem Gleichrichter zugeordnet ist und wobei der Wicklungssinn dieser Wicklung und die Polarisierung dieses Gleichrichters so gewählt sind, daß der Gleichrichter nur während der Abtastperiode aktiv ist.

**Claims**

1. A method for maintaining an electric oscillation circuit with two sequentially commutable oscillation frequencies, for the line sweep of a cathode-ray tube, of the type inducing a maintenance energy in a first inductive winding ($W_1$) connected to said electric oscillation circuit at the common terminal of two condensers (Cr, Cs) belonging to said circuit, and periodically short-circuiting one of these condensers (Cr), with the lower oscillation frequency being established for the sweep trace period of the sweep cycle when that condenser is short-circuited and the higher oscillation frequency being established during the retrace period of the sweep when that condenser is not short-circuited, said method being characterized by the fact that, by means of a second inductive winding (W$_2$) which may be connected to a source (E) of continuous voltage and coupled to said first winding (W$_1$) with a high-electromagnetic coupling coefficient by means of a magnetic circuit (N), it consists in:

— interconnecting the said second winding (W$_2$) to the terminals of said continuous voltage source (E) during each sweep trace period referred to above until a predetermined energy level is reached in said magnetic circuit, while keeping the aforesaid first winding (W$_1$) disconnected from said electric oscillation circuit;

— disconnecting said second winding (W$_2$) from said voltage source when said energy level is reached, while simultaneously connecting said first winding (W$_1$) to the terminals of the aforesaid short-circuited condenser (Cr) until the end of said sweep trace period if said energy level is reached before the end of that sweep trace period;

— breaking the short-circuit at the terminals of said condenser during the entire retrace period, while keeping said first winding (W$_1$) connected to said electric oscillating circuit during at least that retrace period; and

— again disconnecting the said first winding (W$_1$) from said electric oscillating circuit at the beginning of the sweep trace period and simultaneously connecting the said second winding (W$_2$) to the terminals of said source of continuous voltage (E), whereby the first winding (W$_1$) cannot be short-circuited.

2. A method according to claim 1, characterized in that said second winding (W$_2$) is connected to the terminals of said source (E) of continuous voltage only during the beginning of the following sweep trace period until such time as an energy level close to nil is reached in said magnetic circuit (N).

3. A horizontal deflection device for a cathode-ray tube, the device including:

— an oscillating circuit connected to a first inductive winding (W$_1$) and including the deflector (Ly) of the said cathode-ray tube as well as two condensers (Cr, Cs), one of these condensers (Cr) being connected between a connection terminal of the said first winding to the said oscillating circuit and a reference potential terminal;

— a first controlled switch (I$_1$) connected to the terminals of that condenser (Cr) in order to short-circuit it during each sweep trace period and to place it in service in the said oscillating circuit during each retrace period of the sweep; and

— a second inductive winding (W$_2$) coupled to the first winding through a magnetic circuit and connected to a source of continuous voltage (E) through a second controlled switch (I$_2$), the first winding never being short-circuited when the second winding is connected to the voltage source, the controlled switches being of the active type showing a forced switching in a first current flow direction and a natural switching in the opposed direction, characterized in that the magnetic coupling between the said first (W$_1$) and second (W$_2$) windings is close and that it further includes a third controlled switch (I$_3$) of the same kind as the two first mentioned switches, branched in series with said first winding (W$_1$) between the said reference potential terminal and the said connection point, the second and third switches (I$_2$ and I$_3$) being operated in phase opposition.

4. A horizontal deflection device for a cathode-ray tube, the device including:

— an oscillating circuit connected to a first inductive winding (W$_1$) and including the deflector (Ly) of the said cathode-ray tube as well as two condensers (Cr, Cs), one of these condensers (Cr) being connected between a connection terminal of the said first winding to the said oscillating circuit and a reference potential terminal;

— a first controlled switch (I$_1$) connected to the terminals of that condenser (Cr) in order to short-circuit it during each sweep trace period and to place it in service in the said oscillating circuit during each retrace period of the sweep; and

— a second inductive winding (W$_2$) coupled to the first winding through a magnetic circuit and connected to a source of continuous voltage (E) through a second controlled switch (I$_2$), the first winding never being short-circuited when the second winding is connected to the voltage source, the controlled switches being of the active type showing a forced switching in a first current flow direction and a natural switching in the opposed direction, characterized in that said third switch (I'$_3$) is a diode (D'3) with a relatively long recovery time taking into account the sweep retrace period, this diode being arranged in series connection with said first winding (W$_1$) between said reference potential terminal and said connection point, the second and third switches (I$_2$ and I'$_3$) being operated in phase opposition.

5. A device according to claim 4, characterized in that the said diode (D'$_3$) is wired in between a terminal of the said first winding (W$_1$) and the said reference potential.

6. A device according to claim 5, characterized in that this diode (D'$_3$) has a recovery time at least equal to half the sweep retrace period of said deflector (Ly).

7. A device according to one of claims 4 to 6, characterized in that said diode (D'₃) has a recovery time greater than 5 microseconds.

8. A device according to one of claims 4 to 7, characterized in that said diode (D'₃) is of a type customarily intended for the rectification of alternating current from a 50 Hz or 60 Hz distribution network.

9. A device according to claim 3, characterized in that the said third controlled switch (I₃) is wired between a terminal of said first winding (W₁) and the said reference potential and that drive means include notably an additional winding (W₃) wound about said magnetic circuit, one end of which is connected to said reference potential and the other end of which is connected to a control input (T₃) of said third switch, the coupling between said first winding (W₁) and said additional winding (W₃) being close.

10. A device according to one of claims 3 to 9, characterized in that the two first controlled switches consist each of a transistor (T₁, T₂) and a rapid diode (D₁, D₂) connected with reverse polarity between the collector and the emitter of the said transistor, with the base of the transistor constituting a control input of the said switch.

11. A device according to one of the claims 3 to 10, characterized in that the second controlled switch (I₂) is driven by a regulating system (R) to regulate the current in said deflector in sweep retraces.

12. A device according to claim 11, characterized in that it also includes at least one stabilized power supply feed winding (W₄, W₆) coupled magnetically to the said first winding and associated to a rectifier, the direction of wind of said winding and the direction of the wiring in of said rectifier being selected in order that the latter be active only during said retrace period.

13. A device according to one of claims 3 to 12, characterized in that it further includes at least one unstabilized feed winding (W₅) coupled magnetically to the second winding and associated to a rectifier, the direction of wind of said winding and the direction of the wiring in of said rectifier being selected so that the latter be active only during said sweep trace period.

FiG_1

0 033 678

# FIG_2

# FiG_3

0 033 678

FIG_4

4